# EUROPEAN PATENT SPECIFICATION

(11) **EP 4 462 467 B1**
(45) Date of publication and mention of the grant of the patent: **18.02.2026**
(21) Application number: 24169742.4
(22) Date of filing: 11.04.2024
(51) Int. Cl.: H01L 21/48, H01L 21/56, H01L 23/495, H01L 23/00

(54) **METHOD OF MANUFACTURING SEMICONDUCTOR DEVICES**
VERFAHREN ZUR HERSTELLUNG VON HALBLEITERANORDNUNGEN
PROCÉDÉ DE FABRICATION DE DISPOSITIFS SEMI-CONDUCTEURS

(30) Priority: 27.04.2023 IT 202300008289
(43) Date of publication of application: 13.11.2024
(73) Proprietor: STMicroelectronics International N.V., 1228 Plan-les-Ouates, Geneva (CH)
(72) Inventor: BELLIZZI, Antonio, 20093 Cologno Monzese (Milano) (IT); MODARELLI, Nicoletta, 20132 Milano (IT)
(74) Representative: Buzzi, Notaro & Antonielli d'Oulx S.p.A.

(56) References cited:
- EP-A2- 2 680 307
- EP-A2- 4 057 342
- WO-A1-2023/037682
- US-A1- 2005 116 321
- US-A1- 2016 276 251
- US-A1- 2022 344 173
- US-B1- 8 017 447

## Description

### Technical field

The description relates to manufacturing semiconductor devices.

Solutions as described herein can be applied to integrated circuit (IC) semiconductor devices provided with a Quad Flat No-leads -QFN- package for automotive products, for instance.

### Background

Wettable flanks are a desirable feature of integrated circuits semiconductor devices in as much as they enhance solderability of the devices to the final substrate, such as a printed circuit board (PCB), for instance.

Moreover, wettable flanks facilitate automatic optical inspection (AOI) thanks to the formation of a solder meniscus at the flank of the device when soldered to the final substrate.

When concurrently processing a plurality of (IC) semiconductor devices, wettable flanks are conventionally provided via a "half-cut" at the connecting bars which run along the periphery of each individual device. In fact, in current manufacturing processes of (IC) semiconductor devices, a plurality of substrates (leadframes) for individual devices are held together in a leadframe strip using metallic connecting structures including (sacrificial) connecting bars running along the periphery of each device. Multiple devices are thus concurrently processed and finally singulated into individual devices.

Prior to the singulation step, a plating step can be performed in order to plate the leadframe bottom surface with a metallic (solderable) layer, of tin, for instance. The "half-cut" may cause the connecting bars to be exposed at the surface of the leadframe strip during the plating step causing the connecting bars to be plated with a relatively large amount of tin.

A singulating blade removes the connecting bars and the solderable metallic layer plated thereon. Due to the amount of metal accumulated on the connecting bars, the action of the blade during the singulation step may produce flakes or filaments that undesirably "bridge" neighboring leads causing a short circuit therebetween.

Such undesired electrical couplings ("shorts") may cause failure and consequent rejection of the device.

Document EP 4 057 342 A2 discloses a semiconductor device, such as a QFN (Quad-Flat No-lead) package, that comprises one or mode semiconductor chips arranged on a surface of a leadframe. The semiconductor chip(s) is/are arranged at a die pad of the leadframe and the leadframe has an array of electrically-conductive leads around the die pad. The leads in the array have distal ends facing away from the die pad as well as recessed portions of the surface of the leadframe at the distal ends of the leads in the array. Resilient material such as low elasticity modulus material is formed at the recessed portions at the distal ends of the leads in the array, and an insulating encapsulation is molded onto the semiconductor chip(s) arranged on the leadframe. The resilient material is sandwiched between the insulating encapsulation and the distal ends of the leads in the array at the recessed portions and facilitates flexibility of the leads, making them suited for reliable soldering to an insulated metal substrate.

The resilient material is jetted on the upper side of the leads -- before molding.

Document EP 2 680 307 A2 discloses a structure and method to improve saw singulation quality and wettability of integrated circuit packages assembled with lead frames having half-etched recesses in leads. A method of forming a semiconductor device package includes providing a lead frame strip having a plurality of lead frames. Each of the lead frames includes a depression that is at least partially filled with a material prior to singulating the strip.

That document is silent as to the possible presence of an insulating material beyond the molding compound itself.

Document EP 4 099 368 A1 discloses a method of manufacturing semiconductor devices, such as "die pad up" QFN (Quad-Flat No-lead) packages, comprises arranging a plurality of semiconductor chips on an elongated substrate and providing an insulating encapsulation of the semiconductor chips. Electrically conductive formations are plated on the insulating encapsulation. This may comprise Laser Direct Structuring, LDS or Direct Copper Interconnect, DCI material. Plating may include forming electrically conductive plating lines, the plating lines comprising first transverse plating lines as well as second plating lines branching out from the first plating lines the towards the electrically conductive formations. A first partial cutting step removes the first plating lines extending transversely thus replacing them with grooves into which insulating material is dispensed to encapsulate the end portions of the second plating lines. A second cutting step through the elongate substrate having the semiconductor chips arranged thereon and the insulating encapsulation produces singulated semiconductor devices wherein the end portions of the second plating lines are encapsulated by the insulating material.

In that document (which, incidentally, essentially aims at reducing creepage distance violations associated with plating lines remainders after singulation) plating lines extending across the strip-like substrate are (completely) removed by the first cutting step.

The document P. Serra, et al.: "Laser-Induced Forward Transfer: Fundamentals and Applications", in Advanced Materials Technologies/Volume 4, Issue 1 (cited again in the following) provides background information about the use of LIFT tehcnology in the world of electronic devices.

Further prior art documents are WO 2023/037682 A1 and US 2022/344173 A1.

### Object and summary

Solutions as described herein aim at addressing the issues discussed in the foregoing.

Such an object can be achieved via a method having the features set forth in the claims that follow.

The claims are an integral part of the technical teaching provided in respect of the embodiments.

In solutions as described herein, a fairly simple processing step is added to the assembly flow in order to counter filaments/flakes formation which could cause failure of the device.

In solutions as described herein, the connecting bars that are exposed during the plating step are covered with an insulating material to counter growth/deposition of solderable material on the connecting bars.

Solutions as described herein may be advantageously applied to Quad Flat No-leads (QFN) packages provided with wettable flanks.

### Brief description of the several views of the drawings

One or more embodiments will now be described, by way of example only, with reference to the annexed figures, wherein:
Figures 1A, 1B; 2A, 2B; and 3A, 3B are pairs of cross-sectional and plan views, respectively, illustrative of conventional processing steps to provide semiconductor devices with wettable flanks,
Figure 4 is a plan view illustrative of a processing step according to embodiments of the present description,
Figures 5A and 5B are a plan view and a perspective view, respectively, illustrative of a further processing step according to embodiments of the present description, and
Figure 6 is a plan view illustrative of a final singulation step of devices processed according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

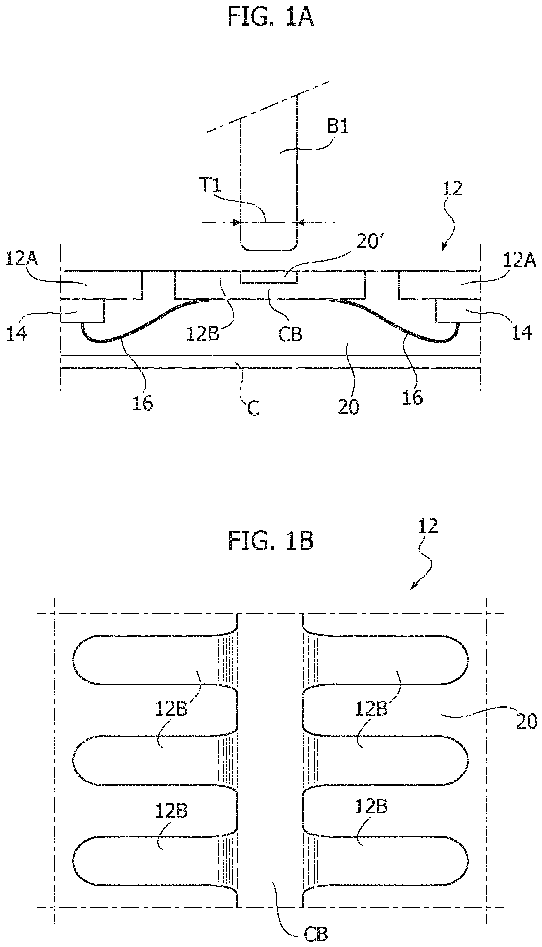

Figures 1A, 1B; 2A, 2B; and 3A, 3B are pairs of cross-sectional and plan views, respectively, illustrative of processing steps according to a conventional approach intended to provide integrated circuit semiconductor (silicon, for instance) devices with wettable flanks.

Figure 1A illustrates a portion of a leadframe reel comprising a plurality of semiconductor devices under (concurrent) processing.

As conventional in the art, these devices comprise a substrate (leadframe) having arranged thereon one or more semiconductor chips or dice 14. As used herein, the terms chip/s and die/dice are regarded as synonymous.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip (the terms chip/s and die/dice are regarded as synonymous) to other electrical components or contacts.

Essentially, a leadframe comprises an array of electrically-conductive formations (or leads, 12B for instance) that from an outline location extend inwardly in the direction of a semiconductor chip or die thus forming an array of electrically-conductive formations from a die pad (12A in Figure 1, for instance) configured to have at least one (integrated circuit) semiconductor chip or die attached on the top/front surface thereof. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by an insulating compound (a resin, for instance) "pre-molded" on the sculptured metal structure.

In current manufacturing processes of (integrated circuit) semiconductor devices plural devices/leadframes are processed concurrently. Concurrent processing of a plurality of devices is achieved by providing a common substrate 12 (e.g., a leadframe strip) comprising a plurality of individual substrates for each device.

In order to concurrently process several devices, several (individual) leadframes are arranged in a leadframe strip 12 and held together via sacrificial connecting bars CB running at the periphery of the individual leadframes.

In the case exemplified in Figure 1A, and in the corresponding plan view of Figure 1B, two devices in the leadframe strip 12 are connected to the same connecting bar CB via their leads 12B. More generally, individual leadframes may be connected to the connecting bars CB both via leads 12B and/or die pads 12A. In certain cases, so-called tie bars may be provided, that is, bridge-like formations that connect the die pads (12A, for instance) or the leads (12B, for instance) of a leadframe to the connecting bars.

As illustrated in the figures, devices in the leadframe strip 12 may comprise:
electrically conductive wires 16 providing electrical coupling between the dice 14 and the leads 12B, and
a molding compound 20 providing an insulating encapsulation to the (IC) semiconductor devices.

Processing of semiconductor devices to obtain devices as illustrated in Figure 1A is conventional in the art thus making unnecessary a more detailed description herein.

The leadframe strip 12 having the chips 14 arranged thereon and provided with the insulating encapsulation of molding compound 20 may be arranged on a carrier C, as illustrated in Figures 1A to 3A, with its bottom/back surface up in order to facilitate further processing.

It is noted that the sequence of steps of Figures 1A, 1B; 2A, 2B, and 3A, 3B is merely exemplary insofar as one or more steps illustrated in the figures can be omitted, performed in a different manner (with other tools, for instance) and additional steps may be added.

Figure 1A illustrates a processing step in providing devices comprised in the leadframe reel with wettable flanks.

As illustrated, connecting bars CB may be "half-etched" and are not exposed at the bottom/back surface of the leadframe reel due to the (pre-)molding compound 20' covering them.

The term "half-etching" is a common designation in the art, which does not imply that such partial etching is by necessity to exactly half the thickness of the base sculptured structure of the leadframe.

A first blade (or saw) B1, having a first thickness T1, is used to perform a partial cut at the connecting bars CB which removes the molding compound 20' covering the connecting bars CB. As illustrated in Figure 1B connecting bars CB are now exposed on the bottom surface of the leadframe reel.

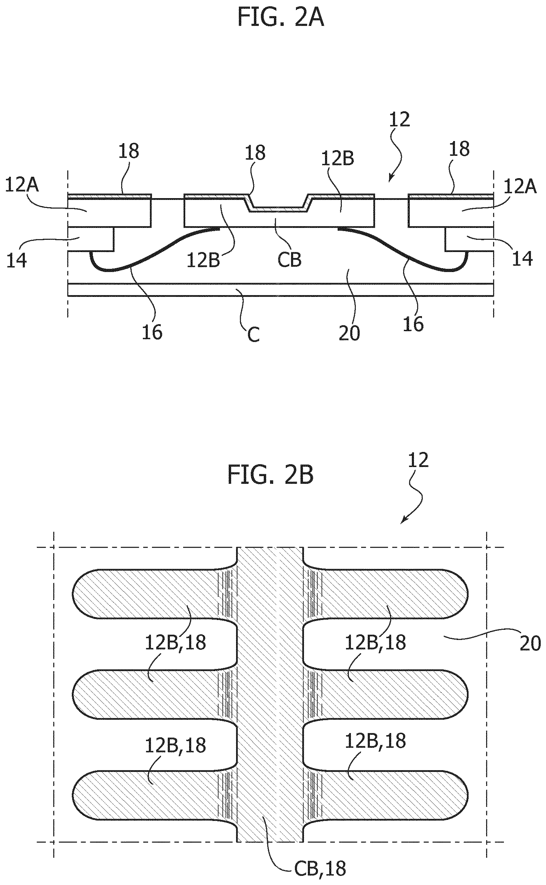

Figures 2A and 2B illustrate a plating step where a layer of solderable material 18 (for instance, tin) is grown/deposited on the second (bottom) surface of the leadframe reel. As illustrated, the exposed surfaces of conductive material (that is, the metallic material of the leadframe) are plated with a layer of solderable material 18. Due to the removal of the molding compound 20' the connecting bars CB are left uncovered during the plating step and are thus plated with a layer of solderable material 18 (tin, for instance).

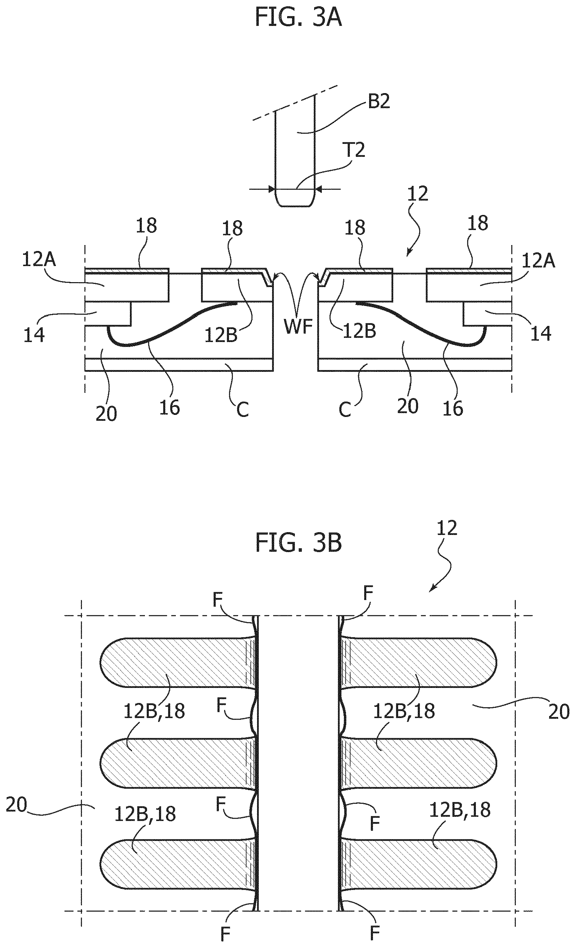

Figure 3A illustrates a final singulation step where the leadframe reel is cut into individual devices. A second, thinner blade B2 having a thickness (width) T2<T1 may be used to perform a full cut of the leadframe reel resulting in the formation of wettable flanks WF on at the periphery of each individual device.

A solderable layer 18 together with wettable flanks WF provided at the periphery of the package enhance solderability of the device to the support substrate the device is intended to be mounted (soldered) on, such as a printed circuit board (PCB) for instance.

Moreover, wettable flanks WF cause the formation of a solder meniscus which facilitates automatic optical inspection of the devices soldered/mounted on the substrate.

However, the conventional approach just described may give raise to some issues due to the fact that connecting bars CB are covered with solderable material when the singulation step is performed.

As illustrated in Figure 3B, due to the relatively large amount of solderable material 18 (tin, for instance) plated on the connecting bars CB, filaments or flakes F may form as a consequence of the action of the singulating blade B2.

As illustrated, filaments/flakes F may establish electrical contact between two neighboring leads 12B, causing an undesired short circuit therebetween and consequent failure (and rejection) of the device.

Formation of filaments F and related issues may be mitigated by frequently replacing the singulation blade B2. In fact, it is observed that filaments F are increasingly formed as the blade deteriorates.

However, frequently replacing the singulating blade may involve higher manufacturing costs and time since the production is halted in order to replace a singulating blade.

In solutions as described herein, formation of filaments/flakes F is reduced by countering plating of the connecting bars CB thus reducing the amount of solderable material the blade removes during singulation.

In solutions as described herein, an insulating material is formed (coated) on the exposed (bottom) surface of the connecting bars CB to counter plating thereof.

Solutions as described herein provide a time- and cost-effective way to reduce the possible formation of filaments F likely to short neighboring leads 12B, thus reducing the number of rejected devices.

It is noted that devices in the leadframe strip 12 as illustrated herein comprise:
electrically conductive wires 16 providing electrical coupling between the dice 14 and the leads 12B, and
a molding compound 20 providing an insulating encapsulation to the IC semiconductor devices.

As illustrated, the molding compound 20 is formed on the die/leadframe -- prior -- to partial cutting indicated as B1 with the insulating material 100 coated on the second surface of the elongate sacrificial connecting bars CB exposed in response to such partial cutting.

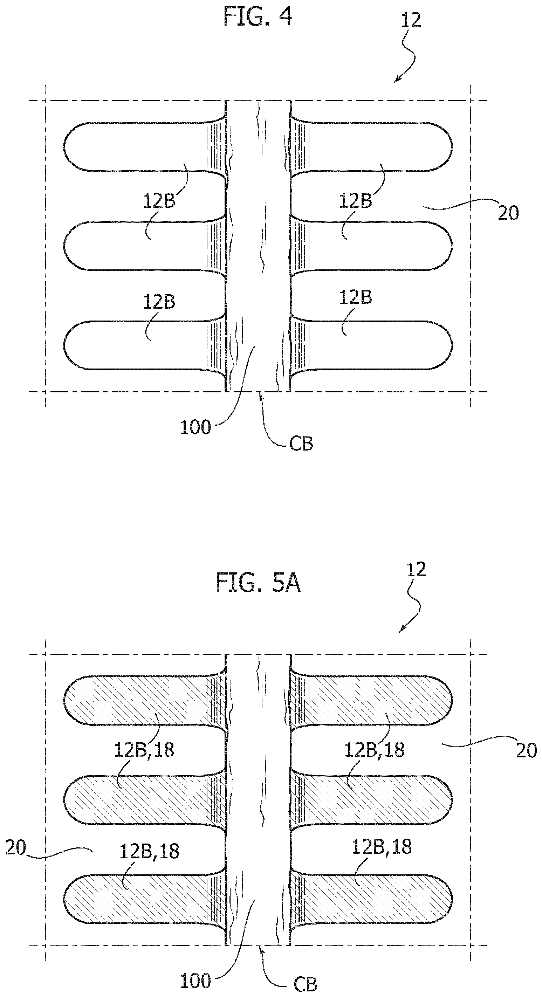

Figure 4 illustrates a portion of the second (back or bottom) surface of a leadframe reel after a partial cut has been performed to remove the molding compound 20 (the portion of molding compound indicated with the reference 20' in Figure 1A) and exposing the connecting bars CB.

As illustrated, a mass of insulating material 100 is formed on the second surface of the connecting bars CB that is exposed as a consequence of the removal of a portion of molding/encapsulation compound 20' (via a partial cut as illustrated in Figure 1A, for instance).

The insulating material 100 may be formed on the connecting bars CB by any method known to those skilled in the art; possible techniques to form/coat insulating material 100 comprise, for instance:
dispensing with a needle, where the amount of material 100 dispensed is controlled via the needle diameter,
jetting, that is, a non-contact method where droplets of insulating material are ejected via a piezoelectric valve, or
laser induced forward transfer, LIFT, a deposition process where material from a donor tape or sheet is transferred to an acceptor substrate facilitated by laser pulses. General information on the LIFT process can be found, for instance, in P. Serra, et al.: "Laser-Induced Forward Transfer: Fundamentals and Applications", in Advanced Materials Technologies/Volume 4, Issue 1.

However formed, the insulating material 100 counters deposition of the solderable layer 18 on the connecting bars CB, thus reducing the amount of solderable material that is removed by the blade (the blade B2 illustrated in Figure 3A, for instance) in the singulations step.

Reducing the amount of solderable material grown/deposited on the connecting bars CB reduces the risk of filaments formation due to the action of the blade during final singulation step.

The insulating material 100 may be chosen to be a curable material in order to make it resistant to the chemicals in the plating bath.

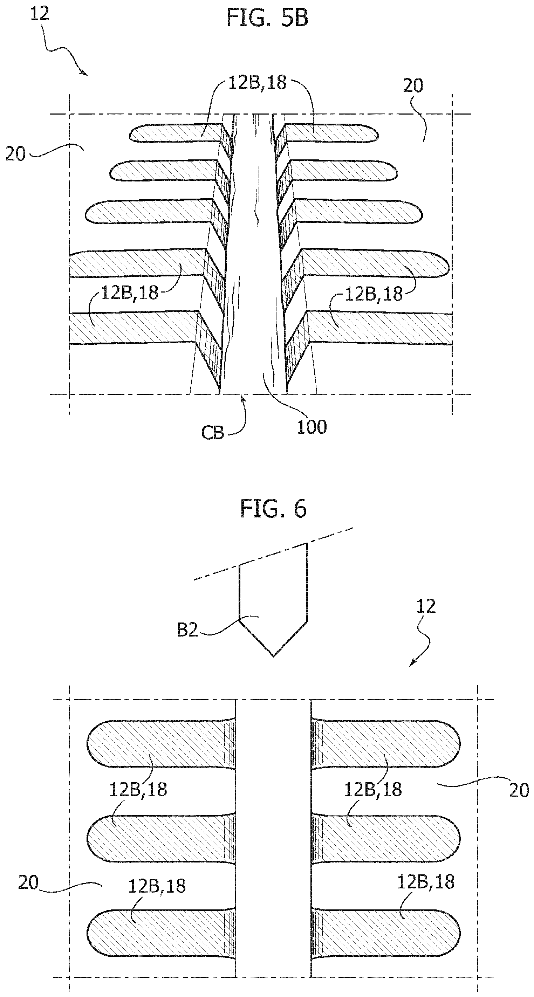

Figures 5A and 5B are, respectively, a plan view and a perspective view of a portion of the second (bottom) surface of a leadframe reel after a plating step is performed.

As illustrated, leads 12B are plated with a layer of solderable material 18 (tin, for instance) as desired, while connecting bars CB covered with a mass of insulating material 100 are not plated.

As visible in Figure 5B, insulating material 100 is formed at the bottom of the trench formed during the partial cut (performed via a blade B1 like the one illustrated in Figure 1A, for instance), leaving the sides of the trench exposed by the insulating material 100. In this way the side surface of the leads 12B are plated with solderable material 18 thus providing wettable flanks WF to the devices in the leadframe strip 12.

Figure 6 is illustrative of the final singulation step performed via a blade B2, for instance, where the connecting bars CB with the insulating material formed 100 thereon are removed in order to separate the leadframe strip 12 into individual devices.

Cutting during the final singulation step thus take place along the length of the elongate sacrificial connecting bars CB that, at those locations where cutting occurs, are exempt from solder material 18 deposited at the second surface due to the presence of the insulating material 100 coated thereon.

The solderable metallic layer 18 is absent from the surface of the connecting bars CB exposed to cutting and the blade will not contact (notionally) the solderable metallic layer 18 plated on the conductive surfaces of the leadframe strip 12, thus reducing the risk of filament formation.

Moreover, due to the lesser amount of solderable material 18 that is removed during the singulation step, wearing of the singulating blade (B2) is reduced.

As described, the material 100 may be advantageously chosen to be:
electrically insulating, in order to counter plating of the connecting bars CB, and
curable, in order to be resistant to the plating bath and the chemicals therein.

An example of such a material is the commercially available product LOCTITE^{®} ABLESTIK 2025D, a nonconductive, heat curing, die attach adhesive that has been seen to have the desired qualities discussed in the foregoing.

In summary, solutions as described herein may be advantageously applied in manufacturing processes where a plurality of integrated circuit semiconductor devices are concurrently processed.

A plurality of semiconductor dice 14 is arranged onto a first (front) surface of a common electrically conductive substrate (such as the leadframe strip 12, for instance) that has a second surface opposite the first surface and comprises substrate portions (the individual leadframes comprising die pads 12A and leads 12B).

The common electrically conductive substrate comprises also elongated connecting bars CB extending between adjacent substrate portions.

Insulating material 100 is formed on the second surface of the elongate sacrificial connecting bars CB and, subsequently, solder material 18 (tin, for instance) is grown on the second (that is, back) surface of the common electrically conductive substrate 12 having the insulating material formed on the second surface of the elongate sacrificial connecting bars (CB).

The insulating (and curable) material 100 counters growth of solder material 18 on the second (back) surface of the elongate sacrificial connecting bars CB thus reducing the risk of filaments formation.

The common electrically conductive substrate 12 is finally cut (via sawing with a blade B2, for instance) along the length of the elongate sacrificial connecting bars (CB) having the insulating material (100) formed on the second surface thereof to provide finished individual devices that are notionally exempt of filaments that may cause undesired shorts (and thus rejection of the device).

According to embodiments of the present description, the second (back) surface of the elongate sacrificial connecting bars CB may be exposed as a consequence of a partial cut (via a blade B1 thicker than the singulating blade B2) intended to provide the package of the devices with wettable flanks.

Without prejudice to the underlying principles, the details and embodiments may vary, even significantly, with respect to what has been described by way of example only without departing from the extent of protection. The extent of protection is determined by the annexed claims.

## Claims

1. A method, comprising:
arranging a plurality of semiconductor dice (14) onto a first surface of a common electrically conductive substrate (12), wherein the common substrate (12) has a second surface opposite the first surface and comprises a plurality of substrate portions (12A, 12B) and elongated sacrificial connecting bars (CB) extending between adjacent substrate portions (12A,12B),
molding a molding compound (20) onto the plurality of semiconductor dice (14) arranged onto the common electrically conductive substrate (12), wherein the molding compound (20') covers said elongated sacrificial connecting bars (CB),
partially cutting (B1) the common electrically conductive substrate (12) starting from the second surface thereof along the elongate sacrificial connecting bars (CB) wherein said partially cutting (B1) removes the molding compound covering (20') said elongated sacrificial connecting bars (CB),
coating insulating material (100) on the second surface of the elongate sacrificial connecting bars (CB) exposed in response to said partially cutting (B1),
growing a solder material (18) on the second surface of the common electrically conductive substrate (12), wherein the insulating material (100) counters growth of the solder material on the second surface of the elongate sacrificial connecting bars (CB), and
providing singulated individual semiconductor devices by cutting (B2) the common electrically conductive substrate (12) having the plurality of semiconductor dice (14) arranged onto the first surface thereof along the length of the elongate sacrificial connecting bars (CB) having the insulating material (100) coated on the second surface thereof.

2. The method of claim 1, wherein the insulating material (100) is a heat curable insulating material.

3. The method of claim 1 or claim 2, wherein the solderable metallic layer comprises tin.

4. The method of claims 1 to 3, wherein the method comprises growing the solderable metallic layer on the second surface of the common electrically conductive substrate (12) via plating.

5. The method of any of the previous claims, comprising coating insulating material (100) on the second surface of the elongate sacrificial connecting bars (CB) via dispensing or jetting.

6. The method of any of the claims 1 to 4, comprising coating insulating material (100) on the second surface of the elongate sacrificial connecting bars (CB) via laser induced forward transfer, LIFT.

7. The method of claim 1, comprising:
partially cutting (B1) the common electrically conductive substrate (12) via a first blade having a first thickness (T1), and
cutting (B2) the common electrically conductive substrate (12) via a second blade having a second thickness (T2),
wherein said first thickness blade (T1) is less than said second thickness (T2) thus providing the wettable flanks (WF) to the semiconductor devices.

## Patentansprüche

1. Verfahren, umfassend:
Anordnen einer Vielzahl von Halbleiterwürfeln (14) auf einer ersten Oberfläche eines gemeinsamen elektrisch leitenden Substrats (12), wobei das gemeinsame Substrat (12) eine zweite, der ersten Oberfläche gegenüberliegende Oberfläche aufweist und eine Vielzahl von Substratabschnitten (12A, 12B) sowie längliche Opferverbindungsstäbe (CB) umfasst, die sich zwischen benachbarten Substratabschnitten (12A, 12B) erstrecken,
Formen einer Formmasse (20) auf die Vielzahl von Halbleiterwürfeln (14), die auf dem gemeinsamen elektrisch leitenden Substrat (12) angeordnet sind, wobei die Formmasse (20') die länglichen Opferverbindungsstäbe (CB) bedeckt,
teilweises Schneiden (B1) des gemeinsamen elektrisch leitenden Substrats (12) ausgehend von seiner zweiten Oberfläche entlang der länglichen Opferverbindungsstäbe (CB), wobei das teilweise Schneiden (B1) die Formmasse entfernt, die die länglichen Opferverbindungsstäbe (CB) bedeckt (20'),
Beschichten von Isoliermaterial (100) auf der zweiten Oberfläche der länglichen Opferverbindungsstäbe (CB), die als Reaktion auf das teilweise Schneiden (B1) freigelegt werden,
Aufwachsen eines Lötmaterials (18) auf der zweiten Oberfläche des gemeinsamen elektrisch leitenden Substrats (12), wobei das Isoliermaterial (100) dem Aufwachsen des Lötmaterials auf der zweiten Oberfläche der länglichen Opferverbindungsstäbe (CB) entgegenwirkt, und
Bereitstellen von einzelnen individuellen Halbleitervorrichtungen durch das Schneiden (B2) des gemeinsamen elektrisch leitenden Substrats (12), auf dem die Vielzahl von Halbleiterwürfeln (14) auf der ersten Oberfläche entlang der Länge der länglichen Opferverbindungsstäbe (CB) angeordnet sind, deren zweite Oberfläche mit dem Isoliermaterial (100) beschichtet ist.

2. Verfahren nach Anspruch 1, wobei das Isoliermaterial (100) ein wärmehärtendes Isoliermaterial ist.

3. Verfahren nach Anspruch 1 oder 2, wobei die lötbare Metallschicht Zinn umfasst.

4. Verfahren nach den Ansprüchen 1 bis 3, wobei das Verfahren das Aufwachsen der lötbaren Metallschicht auf der zweiten Oberfläche des gemeinsamen elektrisch leitenden Substrats (12) durch Plattieren umfasst.

5. Verfahren nach einem der vorhergehenden Ansprüche, das das Beschichten von Isoliermaterial (100) auf der zweiten Oberfläche der länglichen Opferverbindungsstäbe (CB) durch Dosieren oder Spritzen umfasst.

6. Verfahren nach einem der Ansprüche 1 bis 4, das das Beschichten von Isoliermaterial (100) auf der zweiten Oberfläche der länglichen Opferverbindungsstäbe (CB) mittels laserinduzierten Vorwärtstransfers, LIFT, umfasst.

7. Verfahren nach Anspruch 1, das Folgendes umfasst:
teilweises Schneiden (B1) des gemeinsamen elektrisch leitenden Substrats (12) mittels einer ersten Klinge, die eine erste Dicke (T1) aufweist, und
Schneiden (B2) des gemeinsamen elektrisch leitenden Substrats (12) mittels einer zweiten Klinge, die eine zweite Dicke (T2) aufweist,
wobei die erste Klingendicke (T1) kleiner ist als die zweite Dicke (T2), wodurch die benetzbaren Flanken (WF) den Halbleitervorrichtungen bereitgestellt werden.

## Revendications

1. Procédé, comprenant :
d'agencer une pluralité de plaquettes semi-conductrices (14) sur une première surface d'un substrat électriquement conducteur commun (12), dans lequel le substrat commun (12) a une seconde surface opposée à la première surface et comprend une pluralité de parties de substrat (12A, 12B) et de barres de connexion sacrificielles allongées (CB) s'étendant entre des parties de substrat (12A, 12B) adjacentes,
de mouler un composé de moulage (20) sur la pluralité de plaquettes semi-conductrices (14) agencés sur le substrat électriquement conducteur commun (12), dans lequel le composé de moulage (20') couvre lesdites barres de connexion sacrificielles allongées (CB),
de couper partiellement (B1) le substrat électriquement conducteur commun (12) en partant de la seconde surface de celui-ci le long des barres de connexion sacrificielles allongées (CB) dans lequel ladite coupe partielle (B1) enlève le composé de moulage (20') couvrant lesdites barres de connexion sacrificielles allongées (CB),
de revêtir un matériau isolant (100) sur la seconde surface des barres de connexion sacrificielles allongées (CB) exposée en réponse à ladite coupe partielle (B1),
de faire croître un matériau de soudure (18) sur la seconde surface du substrat électriquement conducteur commun (12), dans lequel le matériau isolant (100) empêche la croissance du matériau de soudure sur la seconde surface des barres de connexion sacrificielles allongées (CB), et
de former des dispositifs semi-conducteurs individuels séparés en coupant (B2) le substrat électriquement conducteur commun (12) ayant la pluralité de plaquettes semi-conductrices (14) agencées sur le première surface celui-ci sur la longueur des barres de connexion sacrificielles allongées (CB) ayant le matériau isolant (100) revêtu sur la seconde surface de celles-ci.

2. Procédé selon la revendication 1, dans lequel le matériau isolant (100) est un matériau isolant durcissable par la chaleur.

3. Procédé selon la revendication 1 ou la revendication 2, dans lequel la couche métallique soudable comprend de l'étain.

4. Procédé selon les revendications 1 à 3, dans lequel le procédé comprend de faire croître la couche métallique soudable sur la seconde surface du substrat électriquement conducteur commun (12) par placage.

5. Procédé selon l'une quelconque des revendications précédentes, comprenant de revêtir un matériau isolant (100) sur la seconde surface des barres de connexion sacrificielles allongées (CB) par dispersion ou éjection.

6. Procédé selon l'une quelconque des revendications 1 à 4, comprenant de revêtir un matériau isolant (100) sur la seconde surface des barres de connexion sacrificielles allongées (CB) par transfert vers l'avant induit par laser, LIFT.

7. Procédé selon la revendication 1, comprenant :
de couper partiellement (B1) le substrat électriquement conducteur commun (12) par une première lame ayant une première épaisseur (T1), et
de couper (B2) le substrat électriquement conducteur commun (12) par une seconde lame ayant une seconde épaisseur (T2),
dans lequel ladite première épaisseur (T1) de lame est inférieure à ladite seconde épaisseur (T2) formant ainsi les flancs mouillables (WF) des dispositifs semi-conducteurs.
